(19) **Europäisches Patentamt**

**European Patent Office**

**Office européen des brevets**

(11) **EP 1 143 605 B1**

(12) **EUROPEAN PATENT SPECIFICATION**

(45) Date of publication and mention
of the grant of the patent:
**28.06.2006 Bulletin 2006/26**

(51) Int Cl.:
*H03B 5/32* *(2006.01)*     *H03B 5/36* *(2006.01)*

(21) Application number: **01302164.7**

(22) Date of filing: **09.03.2001**

(54) **An Oscillator circuit**

Eine Oszillatorschaltung

Circuit d'oscillateur

(84) Designated Contracting States:
**DE FR GB**

(30) Priority: **09.03.2000 GB 0005725**

(43) Date of publication of application:
**10.10.2001 Bulletin 2001/41**

(73) Proprietors:
- **TEXAS INSTRUMENTS LIMITED**
  **Northampton Business Park,**
  **Northampton NN4 7YL (GB)**
  Designated Contracting States:
  **GB**
- **TEXAS INSTRUMENTS INCORPORATED**
  **Dallas,**
  **Texas 75251 (US)**
  Designated Contracting States:
  **DE FR**

(72) Inventor: **Harwood, Michael**
**Rushden,**
**Northamptonshire NN10 8NE (GB)**

(74) Representative: **Whiting, Gary**
**Abel & Imray,**
**20 Red Lion Street**
**London WC1R 4PQ (GB)**

(56) References cited:
**US-A- 4 387 349**     **US-A- 5 552 751**

**Description**

The present invention relates to electrical oscillator circuits, and in particular to an oscillator circuit that is suitable for use with a low power supply voltage.

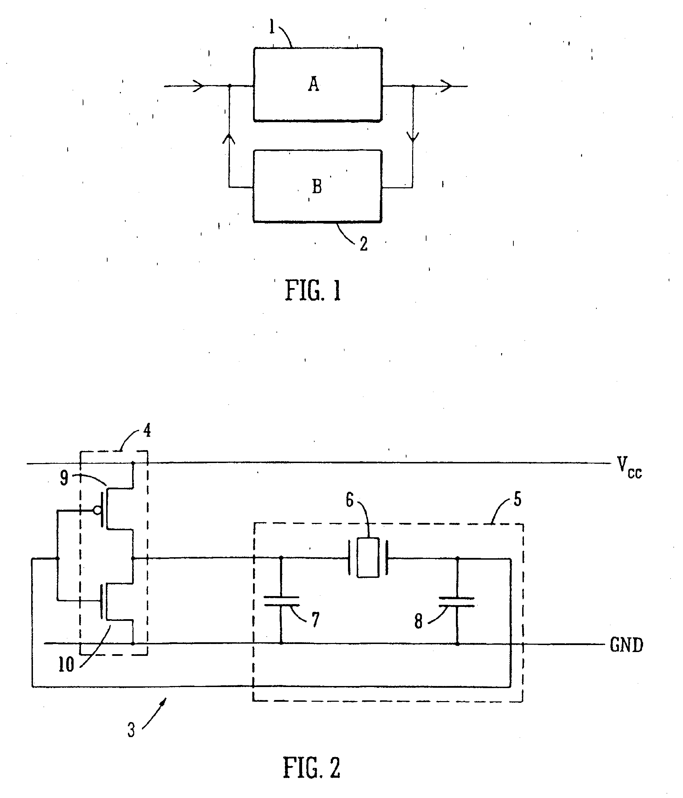

Figure 1 is a block diagram of a well known type of oscillator circuit 1. The circuit comprises an amplifier stage 1 having a gain A and a feedback stage 2 having a gain B. The circuit will tend to oscillate at a frequency at which the loop gain (A x B) is unity and the phase shift around the loop is 360°.

In one form of this oscillator (a Colpitts oscillator) the gain stage 1 is an inverting amplifier and so introduces a phase shift of 180°. The feedback stage 2 is set to give a further shift of 180° but only at the desired frequency of oscillation. This ensures that other frequencies are not reinforced (by not having an overall 360° phase shift) and so are not produced by the oscillator.

Figure 2 is a circuit diagram of a known oscillator circuit 3 of the Colpitts type comprising a standard CMOS inverter 4 as the inverting amplifier 1 and a quartz crystal 6 and two capacitors 7,8 providing the feedback stage 5. The quartz crystal and the two capacitors provide a phase shift of 180° at the resonant frequency of the crystal, when connected as shown to the inverter as a load. A similar circuit is shown in The Art of Electronics (1985) by Horowitz & Hill at p 169.

This circuit 3 works well for supply voltages in excess of 1.8 volts, but is not effective for lower supply voltages. The reason for that is that each transistor 9,10 in the CMOS inverter 4 requires a threshold voltage to be present across the gate-source junction to conduct. The gate source voltage $V_{gs}$ required to turn on the PMOS device 9 is denoted $V_{Tp}$ and that for the NMOS device 10 is denoted $V_{Tn}$. (Further, the more negative of the two supply voltages is herein denoted GND and is taken as the reference point for other potentials in the circuit. The more positive supply voltage is a voltage $V_{cc}$ above that.) To turn on the PMOS transistor 9 the input voltage to the inverter 4 must be $V_{cc}$-$V_{Tp}$ or lower. Similarly to turn on the NMOS transistor 10 the input to the inverter 4 must be at least $V_{Tn}$ (with respect to GND). If $V_{cc}$ is less than $V_{Tp}$ + $V_{Tn}$, there will be a range of inverter input voltages for which both the PMOS 9 and NMOS 10 transistors will be off, and for which the output of the inverter is consequently open circuit. Therefore, in order to function as an inverter, $V_{cc}$ must be at least $V_{Tp}$ + $V_{Tn}$. $V_{Tp}$ and $V_{Tn}$, if the process conditions for the formation of the transistors were good, may be 0.6 V each, but can be higher up to about 1.1 V each if the process conditions are poor. The circuit of Figure 2 will be unviable when the supply falls below about 1.2 V to 2.2 V depending on the process conditions.

It is an object of the present invention to provide an electrical oscillator circuit that is suitable for use with a low voltage supply.

US 4,387,349 discloses an oscillator based on a conventional CMOS oscillator having a CMOS inverter and a feedback circuit including a resonator. The inverter comprises a P-channel transistor biased one threshold voltage below the supply voltage and an N-channel transistor biased one threshold voltage above ground. This form of biasing enables the circuit to oscillate, even with low supply voltages.

US 5,552,751 discloses an oscillator based on a conventional CMOS oscillator having a CMOS inverter and a feedback circuit including a resonator. The inverter comprises a P-channel transistor and an N-channel transistor. The gate of a first of those transistors is coupled to the resonator circuit.
The gate of the second of those transistors is coupled to a level shifter for shifting the gate voltage of the second transistor relative to the gate voltage of the first transistor, thereby enabling the circuit to oscillate at low supply voltages.

According to the present invention there is provided an oscillator circuit comprising:

positive and negative power supplies;
a first p-channel insulated gate field effect transistor having its source connected to the positive power supply, its drain connected to a first output node and its gate connected to a first bias potential;
a first bias generation circuit for providing said first bias potential;
a first n-channel insulated gate field effect transistor having its source connected to the negative power supply and its drain connected to the said first output node; and
a feedback circuit having its input connected to the said first output node and an output connected to the gate of the first NMOS transistor,
wherein the first bias generation circuit comprises:

a second p-channel insulated gate field effect transistor having its source connected to the positive power supply, its drain connected to a second output node and, if the first bias potential is connected to the gate of the first p-channel field effect transistor, having its gate connected to said first bias potential or, if the first bias potential is connected to the first n-channel transistor, having its gate connected to a second bias potential;
a second n-channel insulated gate field effect transistor having its source connected to the negative power supply, its drain connected the said second output node and, if the first bias potential is connected to the gate of the first p-channel transistor, having its gate connected to the second bias potential or, if the first bias potential is connected to the first n-channel transistor, having its gate connected to the first bias potential; and

a control circuit responsive to said second bias potential and the potential at said second output node for so supplying said first bias potential as to reduce the difference between said second bias potential and the potential at said second output node to a minimum value.

Said minimum value may be 50 mV.

Preferably the control circuit comprises an operational amplifier having its non-inverting input connected to the said second output node and its inverting input connected to the second bias potential, wherein the output of the operational amplifier provides the first bias potential.

The second p-channel and the second n-channel transistors may be respective scaled versions of the first PMOS and the first NMOS transistors, the scaling factor being the same for both. The scaling may be achieved by having different width to length ratios for the channels of the said transistors and/or by having multiple first n-channel and/or p-channel transistors connected in parallel.

Preferably the second bias potential is approximately half way between potential of the positive supply and a level equal to potential of the negative power supply plus the gate-source threshold voltage of the first n-channel transistor.

The second bias potential may be provided by a second bias generation circuit comprising a third n-channel insulated gate field effect transistor with its source connected to the negative supply, and its gate and drain connected together and to a potential divider, the potential divider comprising two resistors of equal value, and the node between those two resistors providing said second bias potential.

The first bias generation circuit may be arranged to provide the first bias potential at a level that is below a level equal to the potential of the negative power supply plus the gate-source threshold voltage of the first n-channel transistor.

The oscillator circuit may comprise means for equalising, under DC conditions, the potential of said first output node and that of the gate of said first n-channel transistor, which may be a resistor connected between said first output node and the gate of said first n-channel transistor.

The feedback circuit may be arranged to provide a phase shift of 180° at the frequency of oscillation.

The feedback circuit may comprise a quartz crystal, a ceramic resonator or an inductor, preferably in combination with the capacitors, for example, as described above.

The power supplies for the oscillator circuit may have a potential difference of less than the sum of the gate-source threshold voltages of the said first p-channel and said first n-channel transistors.

Preferably the n-channel and p-channel transistors are enhancement mode transistors.

The p-channel and n-channel transistors may be formed in silicon and have silicon oxide between the channels and the gates.

Alternatively, although it is not preferred, the roles of the p-channel and n-channel transistors may be reversed, with the gates of the first and second n-channel transistors being connected to the first bias voltage, the gate of the first p-channel transistor being connected the output of the feedback circuit and the gate of the second p-channel transistor being connected to the second bias potential.

An embodiment of the invention will now be described, by way of example only, with reference to the accompanying drawings, of which:

FIGURE 1      is a block diagram of a know type of oscillator circuit.

FIGURE 2      is a known oscillator circuit of the type shown in Figure 1.

FIGURE 3      is the basic oscillator circuit of the preferred embodiment of the invention.

FIGURE 4      is a circuit used in the preferred embodiment to set the value of $V_{control}$ in the circuit of Figure 3.

FIGURE 5'      is a graph showing the operating range of the inverter of Figure 3 and the preferred bias point.

FIGURE 6      is a circuit is used in the preferred embodiment used to set the bias voltage in the circuit of Figure 5.

FIGURE 7      is a complete circuit diagram of the preferred embodiment of the present invention.

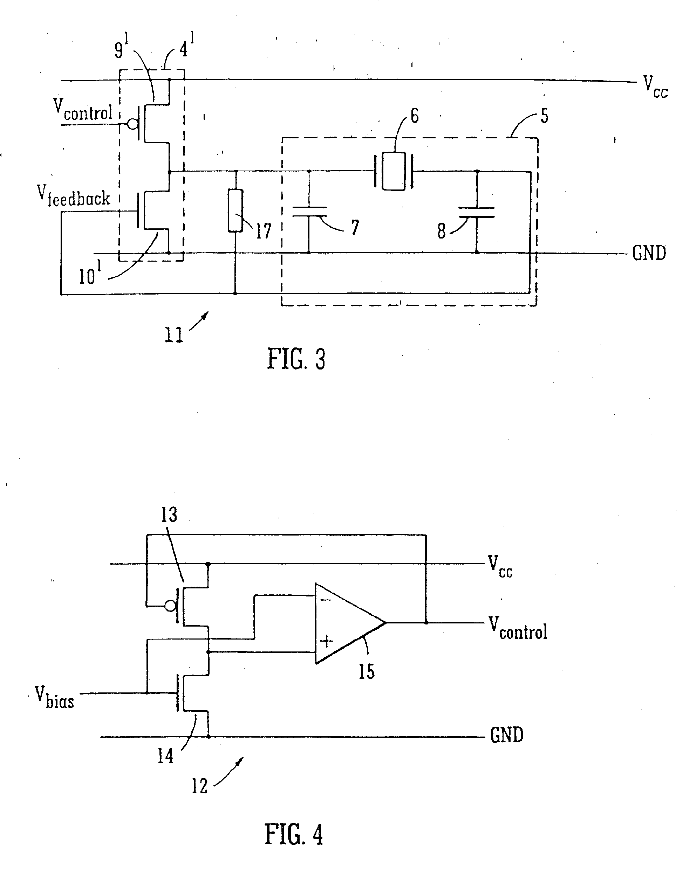

Figure 3 shows the basic oscillator circuit 11 of the preferred embodiment of the present invention. Compared to the prior art circuit of Figure 2 the circuit 11 is the same except that inverter 4' no longer has the gates of the PMOS 9' and NMOS 10' transistors connected in common. The feedback connection from the crystal feedback stage 5 is connected to the gate of the NMOS transistor 10' while the gate of the PMOS transistor 9' is held at a constant bias voltage $V_{control}$. The bias provided turns PMOS transistor 9' on and the feedback signal is inverted through the action of the NMOS transistor 10'. Since the gates are not connected in common, the constraint of $V_{cc}$ being greater than $V_{Tp} + V_{Tn}$ no longer applies, with the result that, if necessary, the gate of the PMOS transistor 9' can be held below $V_{Tn}$ above GND.

Consequently this circuit may be used with low values of $V_{cc}$, in particular less than the 1.2 V to 2.2 V mentioned above.

Figure 4 shows an example of a biasing circuit 12 that is used in the preferred embodiment to provide the bias voltage $V_{control}$ to the gate of the PMOS transistor 9' in the circuit of Figure 3. The control circuit 12 comprises a PMOS 13 and an NMOS transistor 14 that are scaled versions of the respective PMOS 9' and NMOS 10' transistors of Figure 3 i.e. the ratio of the width to length (W/L) ratio of PMOS transistor 9' to the W/L ratio of PMOS transistor 13 is equal the ratio of the W/L ratio of the NMOS transistor 10' to the W/L ratio of NMOS transistor 14. Preferably the W/L ratio for transistors 9' and 10' is fourteen times that for transistors 13 and 14. The transistors 9', 10' of Figure 3 provide substantial currents to drive the oscillator, but those of Figure 4 may be much smaller to save on the area used by the devices. The scaling is more accurate (due to edge effects) if transistors 9' and 10' comprise multiple (preferably fourteen) transistors, identical to transistors 13 and 14, connected in parallel. A further bias voltage $V_{bias}$ is applied to the gate of the NMOS transistor 14 and also to the inverting input of an operational amplifier 15. The drain of the NMOS transistor 14 is connected to the drain of the PMOS transistor 13 and also the non-inverting input of the operational amplifier 15. The output of the operational amplifier is the bias voltage $V_{control}$ applied to the gate input to the PMOS transistor 9' in Figure 3. Further the bias voltage $V_{control}$ is applied to the gate of the PMOS transistor 13 of the control circuit 12 of Figure 4.

The negative feedback in the circuit of Figure 4 ensures that the inverting and non-inverting inputs to the operational amplifier are at approximately the same voltage (i.e. $V_{bias}$) by setting $V_{control}$ to a suitable value to bias the PMOS transistor 13. It is preferred to have a low gain for operational amplifier 15 with the result that the difference between its inputs is held to about 50 mV or less.

Further, the PMOS transistor 9' of the basic oscillator circuit of Figure 3 will also tend to provide $V_{bias}$ as its output voltage (at the node between the PMOS transistor 9' and the NMOS transistor 10') because it has the same gate voltage as the PMOS transistor 13 of the biasing circuit of Figure 4. However, for this to occur more accurately the gate NMOS transistor 10' of the circuit of Figure 3 should also be biased to the same potential as is applied to the gate of the NMOS transistor 14 of the control circuit of Figure 4. This is achieved by connecting a resistor 17 between the output of the inverting amplifier stage 4' of the basic oscillator circuit of Figure 3 and the gate of its NMOS transistor 10'. Further, the DC level of the input to transistor 10' should be set by some means and as stated above this level is preferably $V_{bias}$. (Without the DC level being set, for example, by resistor 17, the behaviour of the oscillator would be ill defined.) Preferably resistor 17 should have a higher impedance than the feedback circuit.

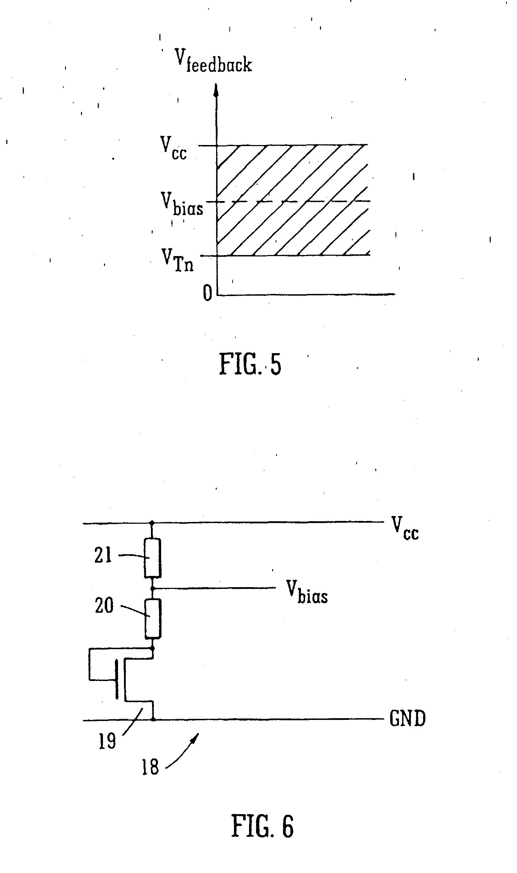

Figure 5 show the operating region of the NMOS transistor 10' of the basic oscillator circuit of Figure 3. If the gate voltage, denoted $V_{feedback}$, is less than that transistor's threshold voltage $V_{Tn}$ then the transistor will be off. With a gate voltage of between $V_{Tn}$ and the positive supply $V_{cc}$ the transistor 10' will conduct, which is denoted by the shaded region in Figure 6, and will be fully on when the gate voltage is $V_{cc}$ (or a little below if transistor 10' is stronger than transistor 9'). Therefore, the bias voltage of the NMOS transistor 14 should preferably be set half way between the supply voltage $V_{cc}$ and the threshold voltage $V_{Tn}$ i.e. at:

$$V_{bias} = (V_{CC}+V_{Tn}) / 2 \ (above \ GND)$$

This enables the output of the inverting stage 4' to swing equally in both directions in response to the input to that stage. Preferably the transistors 91 and 10' should be sized and the bias point chosen to avoid clipping of the waveform output by the oscillator and there may be cases where the ideal bias point is above or below that stated above.

Figure 6 shows a circuit 18 that can be used to provide a suitable bias voltage ($V_{bias}$) for the NMOS transistor 14 circuit of Figure 4. An NMOS transistor 19 is provided with its gate input tied to its drain terminal, and its source input tied to ground. The width to length (W/L) ratio of the transistor is preferably large (i.e. the device is many times wider than it is long) so that the drain input of the NMOS transistor 19 will be set at approximately the threshold voltage of the transistor $V_{Tn}$. This value is process dependent and will therefore be equal to $V_{Tn}$ for the transistor 10' of Figure 3, provided that they are made during the same process at the same time, for example, if they are made on the same die. A pair of resistors 20,21 is connected to provide a simple voltage divider so that $V_{bias}$ is set midway between $V_{cc}$ and $V_{Tn}$, as is preferred. A PMOS transistor (not shown) may be inserted between resistor 21 and $V_{cc}$ with its gate connected to a control signal for disabling the circuit for, for example, during a power saving mode.

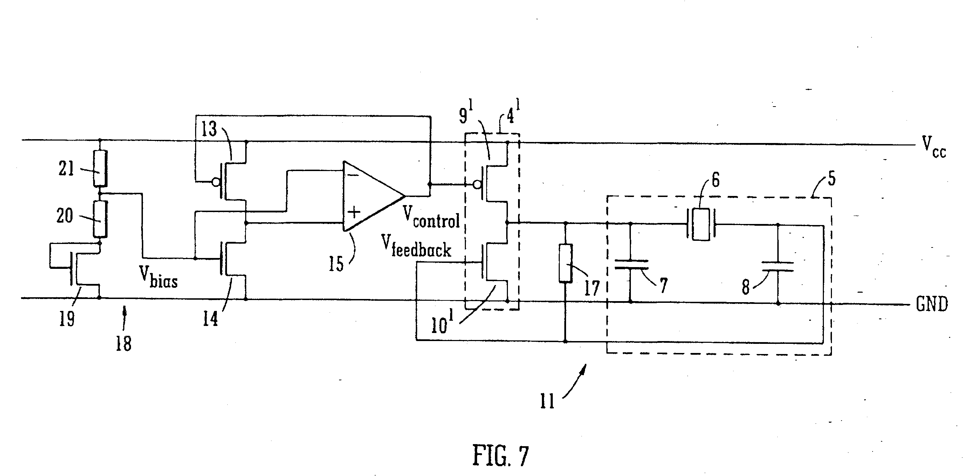

Figure 7 shows the complete circuit diagram of the preferred embodiment of the present invention, with the circuit of Figure 4 setting the value of $V_{control}$ for the circuit of Figure 3, and the circuit of Figure 6 setting the value of $V_{bias}$ for the circuit of Figure 4.

This circuit with the preferred component values listed below is suitable for generating frequencies of 5 to 30 MHz. the output waveform (at the node between the crystal 6 and the capacitor 8) is nearly sinusoidal. (The output of the inverter 4 is a distorted sinusoid.)

| Component | Parameter | Value |
|---|---|---|
| Resistor 20 | resistance | 30 kΩ |
| Resistor 21 | resistance | 30 kΩ |
| Transistor 19 | W/L | 294/0.49 |
| Transistor 13 | W/L | 21/0.49 |
| Transistor 14 | W/L | 7/0.49 |
| Transistor 9' | W/L | 294/0.49 |
| Transistor 10' | W/L | 98/0.49 |
| Resistor 17 | resistance | 150 kΩ |
| Capacitor 8 | capacitance | 20 pF |
| Capacitor 7 | capacitance | 20 pF |
| Crystal 6 | type | parallel fundamental mode crystal |
| Crystal 6 | frequency | 5 to 30 MHz |

While the preferred embodiment uses the quartz crystal feed back circuit 5 (Figure 3) to provide the phase shift, the phase shift could be provided by any other suitable circuit, for example, by using a ceramic resonator or an inductor coil.

An alternative, but not preferred version of the circuit of Figure 7 has the roles of the PMOS and NMOS transistors reversed. In this version $V_{contol}$ is connected to the gates of NMOS transistors 10' and 14, the gate of PMOS transistor 9 is connected to $V_{feedback}$ and the gate of PMSO transistor 13 is connected to $V_{bias}$. $V_{bias}$ is generated by a circuit comprising a PMOS transistor having its source connected together and gate and drain connected to GND via a voltage divider of two equal resistors, $V_{bias}$ being supplied from the node between them.

## Claims

1. An oscillator circuit comprising:

    positive and negative power supplies;
    a first p-channel insulated gate field effect transistor (9') having its source connected to the positive power supply, its drain connected to a first output node and having a gate;
    a first n-channel insulated gate field effect transistor (10') having its source connected to the negative power supply and its drain connected to the said first output node;
    a first bias generation circuit (12) providing a first bias potential ($V_{control}$) to one of the gate of the first p-channel transistor and the gate of the first n-channel transistor; and
    a feedback circuit (5) having its input connected to the said first output node and an output connected to the other of the gate of the first p-channel transistor and the gate of the first n-channel transistor,
    wherein the first bias generation circuit (12) comprises;
    a second p-channel insulated gate field effect transistor (13) having its source connected to the positive power supply and its drain connected to a second output node; and
    a second n-channel insulated gate field effect transistor (14) having its source connected to the negative power supply and its drain connected the said second output node,
    **characterised in that**:

        if the first bias potential is connected to the gate of the first p-channel field effect transistor, the second p-channel insulated gate field effect transistor has its gate connected to said first bias potential or, if the first bias potential is connected to the first n-channel transistor, the second p-channel insulated gate field effect transistor has its gate connected to a second bias potential, ($V_{bias}$), the second potential being defined as $V_{bias}=(V_{cc}+V_T)/2$, where $V_{cc}$ is the supply voltage, and $V_T$ is the threshold voltage of the FET to which $V_{bias}$ is applied;
        if the first bias potential is connected to the gate of the first p-channel transistor, the second n-channel insulated gate field effect transistor has its gate connected to the second bias potential or, if the first bias potential is connected to the first n-channel transistor, the second n-channel insulated gate field effect transistor has its gate connected to the first bias potential; and

the first bias generation circuit (12) further comprises a control circuit (15) responsive to said second bias potential and the potential at said second output node for so supplying said first bias potential as to reduce the difference between said second bias potential and the potential at said second output node to a minimum value.

2. An oscillator circuit as claimed in claim 2 wherein said minimum value is less than 50 mV.

3. An oscillator circuit as claimed in claim 2 or claim 2, wherein the control circuit (15) comprises an operational amplifier having its non-inverting input connected to the said second output node and its inverting input connected to the second bias potential, wherein the output of the operational amplifier provides the first bias potential.

4. An oscillator circuit as claimed in any one of claims 1 to 3, wherein the second p-channel transistor (13) and the second n-channel transistor (14) are respective smaller scaled versions of the first p-channel transistor (9') and the first n-channel transistor (10'), the scaling factor being the same for both.

5. An oscillator circuit as claimed in claim 4 wherein the scaling is achieved by having different width to length ratios for the channels of the said transistors.

6. An oscillator circuit as claimed in claim 4 or claim 5 wherein the scaling is achieved by having multiple first n-channel and/or p-channel transistors connected in parallel.

7. An oscillator circuit as claimed in any preceding claim, wherein the second bias potential is approximately half way between potential of the positive supply and a level equal to potential of the negative power supply plus the gate-source threshold voltage of the first n-channel transistor, if the first bias potential is connected to the first p-channel transistor, or is approximately half way between potential of the negative supply and a level equal to potential of the positive power supply minus the gate-source threshold voltage of the first p-channel transistor, if the first bias potential is connected to the first n-channel transistor.

8. An oscillator circuit as claimed in claim 7, wherein the second bias potential is provided by a second bias generation circuit (18) comprising a third n-channel field effect transistor (19) with its source connected to the negative supply, and its gate and drain connected together and to the positive power supply via a potential divider, the potential divider comprising two resistors of equal value, and the node between those two resistors providing said second bias potential, if the first bias potential is connected to the first p-channel transistor, or is provided by a second bias generation circuit comprising a third p-channel insulated gate field effect transistor with its source connected to the positive supply, and its gate and drain connected together and to the negative power supply via a potential divider, the potential divider comprising two resistors of equal value, and the node between those two resistors providing said second bias potential, if the first bias potential is connected to the first n-channel transistor.

9. An oscillator circuit as claimed in any preceding claim wherein the first bias generation circuit is arranged to provide the first bias potential at a level that is below a level equal to the potential of the negative power supply plus the gate-source threshold voltage of the first n-channel transistor, if it is connected to the first p-channel transistor, or to provide the first bias potential at a level that is above a level equal to the potential of the positive power supply minus the gate-source threshold voltage of the first p-channel transistor, if it is connected to the first n-channel transistor.

10. An oscillator circuit as claimed in any preceding claim comprising means for equalising, under DC conditions, the potential of said first output node and the potential of the gate of said first n-channel transistor if the first bias potential is connected to the first p-channel transistor, or for equalising, under DC conditions, the potential of said first output node and the potential of the gate of said first p-channel transistor if the first bias potential is connected to the first n-channel transistor.

11. An oscillator circuit as claimed in claim 10, wherein said means for equalising comprises a resistor (17) connected between said first output node and the gate of said first n-channel transistor if the first bias potential is connected to the first p-channel transistor, or comprises a resistor connected between said first output node and the gate of said first p-channel transistor if the first bias potential is connected to the first n-channel transistor.

**12.** An oscillator circuit as claimed in any preceding claim, wherein the feedback circuit (5) is arranged to provide a phase shift of 180° at the frequency of oscillation.

**13.** An oscillator circuit as claimed in any preceding claim, wherein the feedback circuit comprises a quartz crystal (6).

**14.** An oscillator circuit as claimed in any one of claims 1 to 12, wherein the feedback circuit comprises a ceramic resonator.

**15.** An oscillator circuit as claimed any one of claims 1 to 12 wherein the feedback circuit comprises an inductor.

**16.** An oscillator circuit as claimed in any preceding claim wherein the first bias potential is connected to the first p-channel transistor (9').

**17.** An oscillator circuit as claimed in any one of claims 1 to 15 wherein the first bias potential is connected to the first n-channel transistor (10').

**18.** An oscillator circuit as claimed in any preceding claim wherein the said insulated gate field effect transistors have oxide gates.

**19.** A circuit comprising an oscillator circuit as claimed in any preceding claim arranged to provide a potential difference between the said positive and negative power supplies of less than the sum of the gate-source threshold voltages of the said first p-channel and said first n-channel transistors.

**Patentansprüche**

**1.** Oszillatorschaltung, mit:

einer positiven und einer negativen Stromversorgung;
einem p-Kanal-Feldeffekttransistor (9') mit isoliertem Gate, dessen Source mit der positiven Stromversorgung verbunden ist und dessen Drain mit einem ersten Ausgangsknoten verbunden ist und der ein Gate besitzt;
einem ersten n-Kanal Feldeffekttransistor (10') mit isoliertem Gate, dessen Source mit der negativen Stromversorgung verbunden ist und dessen Drain mit dem ersten Ausgangsknoten verbunden ist;
einer ersten Vorspannungserzeugungsschaltung (12), die ein erstes Vorspannungspotential ($V_{control}$) für das Gate des ersten p-Kanal-Transistors oder das Gate des ersten n-Kanal-Transistors bereitstellt; und
einer Rückkopplungsschaltung (5), deren Eingang mit dem ersten Ausgangsknoten verbunden ist und deren Ausgang mit dem Gate des jeweils anderen des ersten p-Kanal-Transistors bzw. des ersten n-Kanal-Transistors verbunden ist,
wobei die erste Vorspannungserzeugungsschaltung (12) umfasst:

einen zweiten p-Kanal-Feldeffekttransistor (13) mit isoliertem Gate, dessen Source mit der positiven Stromversorgung verbunden ist und dessen Drain mit einem zweiten Ausgangsknoten verbunden ist; und
einen zweiten n-Kanal-Feldeffekttransistor (14) mit isoliertem Gate, dessen Source mit der negativen Stromversorgung verbunden ist und dessen Drain mit dem zweiten Ausgangsknoten verbunden ist,
**dadurch gekennzeichnet, dass**:

der zweite p-Kanal-Feldeffekttransistor mit isoliertem Gate dann, wenn das erste Vorspannungspotenzial mit dem Gate des ersten p-Kanal-Feldeffekttransistors verbunden ist, mit seinem Gate mit dem ersten Vorspannungspotenzial verbunden ist und dann, wenn das erste Vorspannungspotenzial mit dem ersten n-Kanal-Transistor verbunden ist, mit seinem Gate mit einem zweiten Vorspannungspotenzial ($V_{bias}$) verbunden ist;
der zweite n-Kanal-Feldeffekttransistor mit isoliertem Gate dann, wenn das erste Vorspannungspotenzial mit dem Gate des ersten p-Kanal-Transistors verbunden ist, mit seinem Gate mit dem zweiten Vorspannungspotenzial verbunden ist und dann, wenn das erste Vorspannungspotenzial mit dem ersten n-Kanal-Transistor verbunden ist, mit seinem Gate mit dem ersten Vorspannungspotenzial verbunden ist; und
die erste Vorspannungserzeugungsschaltung (12) ferner eine Steuerschaltung (15) enthält, die in Reaktion auf das Vorspannungspotenzial und das Potenzial am zweiten Ausgangsknoten das erste Vorspannungspotenzial liefert, um die Differenz zwischen dem zweiten Vorspannungspotenzial und dem Potenzial an dem zweiten Ausgangsknoten auf einen Minimalwert zu verringern.

2. Oszillatorschaltung nach Anspruch 1, bei der der Minimalwert weniger als 50 mV beträgt.

3. Oszillatorschaltung nach Anspruch 1 oder Anspruch 2, bei der die Steuerschaltung (15) einen Operationsverstärker umfasst, dessen nichtinvertierender Eingang mit dem zweiten Ausgangsknoten verbunden ist und dessen invertierender Eingang mit dem zweiten Vorspannungspotenzial verbunden ist, wobei der Ausgang des Operationsverstärkers das erste Vorspannungspotenzial bereitstellt.

4. Oszillatorschaltung nach einem der Ansprüche 1 bis 3, bei der der zweite p-Kanal-Transistor (13) und der zweite n-Kanal-Transistor (14) jeweils kleiner skalierte Versionen des ersten p-Kanal-Transistors (9') bzw. des ersten n-Kanal-Transistors (10') sind, wobei der Skalierungsfaktor für beide gleich ist.

5. Oszillatorschaltung nach Anspruch 4, bei der die Skalierung durch unterschiedliche Breiten/Längen-Verhältnisse für die Kanäle der Transistoren erzielt wird.

6. Oszillatorschaltung nach Anspruch 4 oder Anspruch 5, bei der die Skalierung durch mehrere erste n-Kanal- und/ oder p-Kanal-Transistoren, die parallel geschaltet sind, erzielt wird.

7. Oszillatorschaltung nach einem vorhergehenden Anspruch, bei der das zweite Vorspannungspotenzial angenähert in der Mitte zwischen dem Potenzial der positiven Versorgung und einem Pegel, der gleich dem Potenzial der negativen Stromversorgung plus der Gate-Source-Schwellenspannung des ersten n-Kanal-Transistors ist, liegt, falls das erste Vorspannungspotenzial mit dem ersten p-Kanal-Transistor verbunden ist, oder angenähert in der Mitte zwischen dem Potenzial der negativen Versorgung und einem Pegel, der gleich dem Potenzial der positiven Stromversorgung minus der Gate-Source-Schwellenspannung des ersten p-Kanal-Transistors ist, liegt, falls das erste Vorspannungspotenzial mit dem ersten n-Kanal-Transistor verbunden ist.

8. Oszillatorschaltung nach Anspruch 7, bei der das zweite Vorspannungspotenzial durch eine zweite Vorspannungserzeugungsschaltung (18) bereitgestellt wird, die einen dritten n-Kanal-Feldeffekttransistor (19) aufweist, dessen Source mit der negativen Versorgung verbunden ist und dessen Gate und dessen Drain miteinander und über einen Potenzialteiler mit der positiven Stromversorgung verbunden sind, wobei der Potenzialteiler zwei ohmsche Widerstände mit gleichem Wert aufweist und wobei das zweite Vorspannungspotenzial durch den Knoten zwischen diesen beiden ohmschen Widerständen bereitgestellt wird, falls das erste Vorspannungspotenzial mit dem ersten p-Kanal-Transistor verbunden ist, oder durch eine zweite Vorspannungserzeugungsschaltung bereitgestellt wird, die einen dritten p-Kanal-Feldeffekttransistor mit isoliertem Gate umfasst, dessen Source mit der positiven Versorgung verbunden ist und dessen Gate und dessen Drain miteinander und über einen Potenzialteiler mit der negativen Stromversorgung verbunden sind,
wobei der Potenzialteiler zwei ohmsche Widerstände mit gleichem Wert aufweist und wobei das zweite Vorspannungspotenzial durch den Knoten zwischen diesen beiden ohmschen Widerständen bereitgestellt wird, falls das erste Vorspannungspotenzial mit dem ersten n-Kanal-Transistor verbunden ist.

9. Oszillatorschaltung nach einem vorhergehenden Anspruch, bei der die erste Vorspannungserzeugungsschaltung so beschaffen ist, dass sie das erste Vorspannungspotenzial auf einem Pegel bereitstellt, der unter einem Pegel liegt, der gleich dem Potenzial der negativen Stromversorgung plus der Gate-Source-Schwellenspannung des ersten n-Kanal-Transistors ist, falls sie mit dem ersten p-Kanal-Transistor verbunden ist, oder das erste Vorspannungspotenzial mit einem Pegel bereitstellt, der über einem Pegel liegt, der gleich dem Potenzial der positiven Stromversorgung minus der Gate-Source-Schwellenspannung des ersten p-Kanal-Transistors ist, falls sie mit dem ersten n-Kanal-Transistor verbunden ist.

10. Oszillatorschaltung nach einem vorhergehenden Anspruch, die Mittel umfasst, um unter Gleichspannungsbedingungen das Potenzial des ersten Ausgangsknotens und das Potenzial des Gates des ersten n-Kanal-Transistors einander anzugleichen, falls das erste Vorspannungspotenzial mit dem ersten p-Kanal-Transistor verbunden ist, oder um unter Gleichspannungsbedingungen das Potenzial des ersten Ausgangsknotens und das Potenzial des Gates des ersten p-Kanal-Transistors einander anzugleichen, falls das erste Vorspannungspotenzial mit dem ersten n-Kanal-Transistor verbunden ist.

11. Oszillatorschaltung nach Anspruch 10, bei der die Angleichungsmittel einen ohmschen Widerstand (17) umfassen, der zwischen den ersten Ausgangsknoten und das Gate des ersten n-Kanal-Transistors geschaltet ist, falls das erste Vorspannungspotenzial mit dem ersten p-Kanal-Transistor verbunden ist, oder einen ohmschen Widerstand umfassen, der zwischen den ersten Ausgangsknoten und das Gate des ersten p-Kanal-Transistors geschaltet ist, falls das erste Vorspannungspotenzial mit dem ersten n-Kanal-Transistor verbunden ist.

12. Oszillatorschaltung nach einem vorhergehenden Anspruch, bei der die Rückkopplungsschaltung (5) so beschaffen ist, dass sie bei der Oszillationsfrequenz eine Phasenverschiebung von 180° schafft.

13. Oszillatorschaltung nach einem vorhergehenden Anspruch, bei der die Rückkopplungsschaltung einen Quarzkristall (6) enthält.

14. Oszillatorschaltung nach einem der Ansprüche 1 bis 12, bei der die Rückkopplungsschaltung einen keramischen Resonator enthält.

15. Oszillatorschaltung nach einem der Ansprüche 1 bis 12, bei der die Rückkopplungsschaltung eine Induktivität enthält.

16. Oszillatorschaltung nach einem vorhergehenden Anspruch, bei der das erste Vorspannungspotenzial mit dem ersten p-Kanal-Transistor (9') verbunden ist.

17. Oszillatorschaltung nach einem der Ansprüche 1 bis 15, bei der das erste Vorspannungspotenzial mit dem ersten n-Kanal-Transistor (10') verbunden ist.

18. Oszillatorschaltung nach einem vorhergehenden Anspruch, bei der die Feldeffekttransistoren mit isoliertem Gate Oxid-Gates besitzen.

19. Schaltung, die eine Oszillatorschaltung nach einem vorhergehenden Anspruch enthält und so beschaffen ist, dass sie eine Potenzialdifferenz zwischen der positiven und der negativen Stromversorgung bereitstellt, die kleiner als die Summe der Gate-Source-Schwellenspannungen des ersten p-Kanal-Transistors und des ersten n-Kanal-Transistors ist.

**Revendications**

1. Circuit d'oscillateur comprenant :

des alimentations positive et négative ;
un premier transistor à effet de champ à grille isolée à canal P (9') dont la source est connectée à l'alimentation positive, le drain est connecté à un premier noeud de sortie et possédant une grille ;
un premier transistor à effet de champ à grille isolée à canal N (10') dont la source est connectée à l'alimentation négative et le drain est connecté audit premier noeud de sortie ;
un premier circuit de génération de polarisation (12) fournissant un premier potentiel de polarisation ($V_{control}$) à l'une de la grille du premier transistor à canal P et de la grille du premier transistor à canal N ; et
un circuit de rétroaction (5) dont l'entrée est connectée audit premier noeud de sortie et la sortie est connectée à l'autre de la grille du premier transistor à canal P et de la grille du premier transistor à canal N,
dans lequel le premier circuit de génération de polarisation (12) comprend ;

un deuxième transistor à effet de champ à grille isolée à canal P (13) dont la source est connectée à l'alimentation positive et le drain est connecté à un second noeud de sortie ; et
un deuxième transistor à effet de champ à grille isolée à canal N (14) dont la source est connectée à l'alimentation négative et le drain est connecté audit second noeud de sortie ;
**caractérisé en ce que** :

si le premier potentiel de polarisation est connecté à la grille du premier transistor à effet de champ à canal P, le deuxième transistor à effet de champ à grille isolée à canal P a sa grille connectée audit premier potentiel de polarisation, ou, si le premier potentiel de polarisation est connecté au premier transistor à canal N, le deuxième transistor à effet de champ à grille isolée à canal P a sa grille connectée à un second potentiel de polarisation ($V_{bias}$) ;
si le premier potentiel de polarisation est connecté à la grille du premier transistor à effet de champ à canal P, le deuxième transistor à effet de champ à grille isolée à canal N a sa grille connectée au second potentiel de polarisation, ou, si le premier potentiel de polarisation est connecté au premier transistor à canal N, le deuxième transistor à effet de champ à grille isolée à canal N a sa grille connectée au premier potentiel de polarisation ; et

le premier circuit de génération de polarisation (12) comprend de plus un circuit de commande (15) sensible audit second potentiel de polarisation et au potentiel au niveau dudit second noeud de sortie pour fournir ainsi ledit premier potentiel de polarisation afin de réduire à une valeur minimum, la différence entre ledit second potentiel de polarisation et le potentiel au niveau dudit second noeud de sortie.

2. Circuit d'oscillateur selon la revendication 1, dans lequel ladite valeur minimum est inférieure à 50 mV.

3. Circuit d'oscillateur selon l'une quelconque des revendications 1 ou 2, dans lequel le circuit de commande (15) comprend un amplificateur opérationnel dont l'entrée non inverseuse est connectée audit second noeud de sortie et l'entrée inverseuse est connectée au second potentiel de polarisation, dans lequel la sortie de l'amplificateur opérationnel fournit le premier potentiel de polarisation.

4. Circuit d'oscillateur selon l'une quelconque des revendications 1 à 3, dans lequel le deuxième transistor à canal P (13) et le deuxième transistor à canal N (14) sont des versions plus réduites du premier transistor à canal P (9') et du premier transistor à canal N (10'), le facteur de réduction étant le même pour les deux.

5. Circuit d'oscillateur selon la revendication 4, dans lequel la réduction est réalisée en ayant différents rapports de la largeur sur la longueur des canaux desdits transistors.

6. Circuit d'oscillateur selon l'une quelconque des revendications 4 ou 5, dans lequel la réduction est réalisée en connectant en parallèle de multiples premiers transistors à canal N et / ou à canal P.

7. Circuit d'oscillateur selon l'une quelconque des revendications précédentes, dans lequel le second potentiel de polarisation se situe à peu près à mi-chemin entre le potentiel de l'alimentation positive et un niveau égal au potentiel de l'alimentation négative plus la tension de seuil grille - source du premier transistor à canal N, si le premier potentiel de polarisation est connecté au premier transistor à canal P, ou, se situe à peu près à mi-chemin entre le potentiel de l'alimentation négative et un niveau égal au potentiel de l'alimentation positive moins la tension de seuil grille - source du premier transistor à canal P, si le premier potentiel de polarisation est connecté au premier transistor à canal N.

8. Circuit d'oscillateur selon la revendication 7, dans lequel le second potentiel de polarisation est fourni par un second circuit de génération de polarisation (18) comprenant un troisième transistor à effet de champ à canal N (19) dont la source est connectée à l'alimentation négative, et la grille et le drain sont connectés ensemble à l'alimentation positive par l'intermédiaire d'un diviseur de tension, le diviseur de tension comprenant deux résistances de valeur égale, et le noeud situé entre ces deux résistances fournissant ledit second potentiel de polarisation, si le premier potentiel de polarisation est connecté au premier transistor à canal P, ou, est fourni par un second circuit de génération de polarisation comprenant un troisième transistor à effet de champ à grille isolée à canal P dont la source est connectée à l'alimentation positive, et la grille et le drain sont connectés ensemble à l'alimentation négative par l'intermédiaire d'un diviseur de tension, le diviseur de tension comprenant deux résistances de valeur égale, et le noeud situé entre ces deux résistances fournissant ledit second potentiel de polarisation, si le premier potentiel de polarisation est connecté au premier transistor à canal N.

9. Circuit d'oscillateur selon l'une quelconque des revendications précédentes, dans lequel le premier circuit de génération de polarisation est agencé afin de fournir le premier potentiel de polarisation à un niveau qui est en dessous d'un niveau égal au potentiel de l'alimentation négative plus la tension de seuil grille - source du premier transistor à canal N, s'il est connecté au premier transistor à canal P, ou, pour fournir le premier potentiel de polarisation à un niveau qui est au-dessus d'un niveau égal au potentiel de l'alimentation positive mois la tension de seuil grille - source du premier transistor à canal P, s'il est connecté au premier transistor à canal N.

10. Circuit d'oscillateur selon l'une quelconque des revendications précédentes, comprenant des moyens pour égaliser, dans des conditions en courant continu, le potentiel dudit premier noeud de sortie et le potentiel de la grille dudit premier transistor à canal N si le premier potentiel de polarisation est connecté au premier transistor à canal P, ou, pour égaliser, dans des conditions en courant continu, le potentiel dudit premier noeud de sortie et le potentiel de la grille dudit premier transistor à canal P si le premier potentiel de polarisation est connecté au premier transistor à canal N.

**11.** Circuit d'oscillateur selon la revendication 10, dans lequel lesdits moyens pour égaliser comprennent une résistance (17) connectée entre ledit premier noeud de sortie et la grille dudit premier transistor à canal N si le premier potentiel de polarisation est connecté au premier transistor à canal P, ou, comprennent une résistance connectée entre ledit premier noeud de sortie et la grille dudit premier transistor à canal P si le premier potentiel de polarisation est connecté au premier transistor à canal N.

**12.** Circuit d'oscillateur selon l'une quelconque des revendications précédentes, dans lequel le circuit de rétroaction (5) est agencé pour fournir un déphasage de 180° à la fréquence d'oscillation.

**13.** Circuit d'oscillateur selon l'une quelconque des revendications précédentes, dans lequel le circuit de rétroaction comprend un cristal de quartz (6).

**14.** Circuit d'oscillateur selon l'une quelconque des revendications 1 à 12, dans lequel le circuit de rétroaction comprend un résonateur céramique.

**15.** Circuit d'oscillateur selon l'une quelconque des revendications 1 à 12, dans lequel le circuit de rétroaction comprend une inductance.

**16.** Circuit d'oscillateur selon l'une quelconque des revendications précédentes, dans lequel le premier potentiel de polarisation est connecté au premier transistor à canal P (9').

**17.** Circuit d'oscillateur selon l'une quelconque des revendications 1 à 15, dans lequel le premier potentiel de polarisation est connecté au premier transistor à canal N (10').

**18.** Circuit d'oscillateur selon l'une quelconque des revendications précédentes, dans lequel lesdits transistors à effet de champ à grille isolée ont des grilles à couche d'oxyde.

**19.** Circuit comprenant un circuit d'oscillateur, selon l'une quelconque des revendications précédentes, agencé pour fournir une différence de potentiel entre lesdites alimentations positive et négative, inférieure à la somme des tensions de seuil grille - source desdits premiers transistors à canal P et desdits premiers transistors à canal N.

FIG. 1

FIG. 2

FIG. 3

FIG. 4

$V_{feedback}$

$V_{cc}$

$V_{bias}$

$V_{Tn}$

0

FIG. 5

$V_{cc}$

21

20 — $V_{bias}$

19

18

GND

FIG. 6

FIG. 7

EP 1 143 605 B1